# FASCICULE DE BREVET EUROPEEN

(11) **EP 2 824 677 B1**
(45) Date de publication et mention de la délivrance du brevet: **28.02.2018**
(21) Numéro de dépôt: 14176171.8
(22) Date de dépôt: 08.07.2014
(51) Int. Cl.: H01F 7/16, H01H 9/54, H01H 71/04, G01D 5/20, H01H 71/24, H01H 9/16, H01F 7/18, H01H 71/50

(54) **Dispositif de détection du réarmement d'un disjoncteur, actionneur d'un mécanisme de séparation des contacts du disjoncteur, disjoncteur électrique et utilisation d'un courant induit pour générer un signal d'indication du réarmement**
Vorrichtung zur Erkennung der Entsperrung eines Trennschalters, Stellglied eines Kontakttrennungsmechanismus des Trennschalters, elektrischer Trennschalter und Verwendung eines induzierten Stroms zur Erzeugung eines Anzeigesignals der Entsperrung
Device for detecting the resetting of a circuit breaker, actuator of a mechanism for separating the contacts of the circuit breaker, electric circuit breaker and use of an induced current to generate a signal to indicate the reset

(30) Priorité: 09.07.2013 FR 1356745
(43) Date de publication de la demande: 14.01.2015
(73) Titulaire: Schneider Electric Industries SAS, 92500 Rueil-Malmaison (FR)
(72) Inventeur: Houbre, Pascal, 38050 Grenoble Cedex 09 (FR); Odille, Fabien, 38050 Grenoble Cedex 09 (FR)
(74) Mandataire: Lavoix

(56) Documents cités:
- DE-A1- 10 240 774
- DE-U1-202005 011 901
- FR-A1- 2 893 445

## Description

La présente invention concerne l'utilisation d'une impulsion électrique associée à un courant induit pour générer un signal d'indication du réarmement d'un disjoncteur. En particulier, la présente invention concerne l'utilisation d'une impulsion électrique associée à un courant induit dans une bobine d'un actionneur d'un mécanisme de séparation des contacts fixe et mobile d'un disjoncteur électrique, pour détecter un réarmement du disjoncteur.

Le document DE 20 2005 011 901 U1 décrit l'utilisation d'une impulsion électrique correspondant à un courant électrique induit dans une bobine d'un actionneur pour générer un signal d'indication d'actionnement extérieur de l'actionneur, le courant étant induit dans la bobine par le déplacement d'un noyau mobile entre deux positions, le noyau mobile étant inclus dans l'actionneur. Le document FR 2 893 445 A1 décrit un relais électromagnétique polarisé à accroche magnétique.

On connaît du document WO 2007/137938 A1 un dispositif de détection destiné à être implanté dans un disjoncteur électrique. Le disjoncteur électrique présente trois états possibles, à savoir un état « Marche », un état « Arrêt » et un état « Déclenché », le passage de l'état « Marche » à l'état « Déclenché » correspondant au déclenchement du disjoncteur, effectué de manière automatique lors de la détection d'un défaut électrique, tel qu'un court-circuit. Le disjoncteur électrique comporte un boîtier sur lequel est monté une manette d'actionnement, montée pivotante ou rotative, la manette étant mobile entre trois positions correspondant respectivement aux trois états du disjoncteur.

Le dispositif de détection permet de détecter l'état du disjoncteur parmi les trois états possibles, et comporte une plaquette mobile en translation, couplée mécaniquement à la manette du disjoncteur et apte à prendre trois positions correspondant aux trois états du disjoncteur. La plaquette mobile porte un dispositif magnétique à un ou deux aimants permanents, destiné à actionner des micro-interrupteurs entre leurs deux positions.

Toutefois, un tel dispositif de détection est relativement coûteux, et nécessite d'être couplé mécaniquement à la manette du disjoncteur.

Le but de l'invention est donc de proposer une utilisation d'une impulsion électrique pour détecter un réarmement d'un disjoncteur qui soit plus facile à mettre en oeuvre, tout en étant moins coûteux.

Á cet effet, l'invention a pour objet une utilisation d'une impulsion électrique associée à un courant induit pour générer un signal d'indication du réarmement d'un disjoncteur comme définit dans la revendication 1.

D'autres aspects avantageux de l'invention sont définis dans les revendications dépendantes.

D'autres caractéristiques et avantages de l'invention apparaîtront à la lecture de la description qui va suivre, donnée uniquement à titre d'exemple non limitatif, et faite en référence aux dessins annexés, sur lesquels :
- la figure 1 est une représentation schématique d'un disjoncteur comportant des contacts fixe et mobile, un mécanisme de séparation des contacts et un actionneur du mécanisme de séparation ;
- les figures 2 et 3 sont des vues en coupe de l'actionneur de la figure 1, l'actionneur comportant une bobine électromagnétique, un noyau mobile entre une position de repos et une position de travail dans laquelle le mécanisme de séparation est actionné et un dispositif de détection du réarmement du disjoncteur, le noyau étant en position de repos sur la figure 2 et en position de travail sur la figure 3 ;
- la figure 4 est un schéma électrique du dispositif de détection comportant des moyens de génération d'un signal d'indication du réarmement du disjoncteur à partir d'une impulsion électrique, l'impulsion électrique correspondant à un courant électrique induit dans la bobine par le déplacement du noyau mobile de sa position de travail vers sa position de repos lors du réarmement du disjoncteur ;
- la figure 5 est un ensemble de courbes représentant respectivement l'impulsion électrique et le signal d'indication généré ; et
- la figure 6 est une vue analogue à celle de la figure 4 selon un deuxième mode de réalisation.

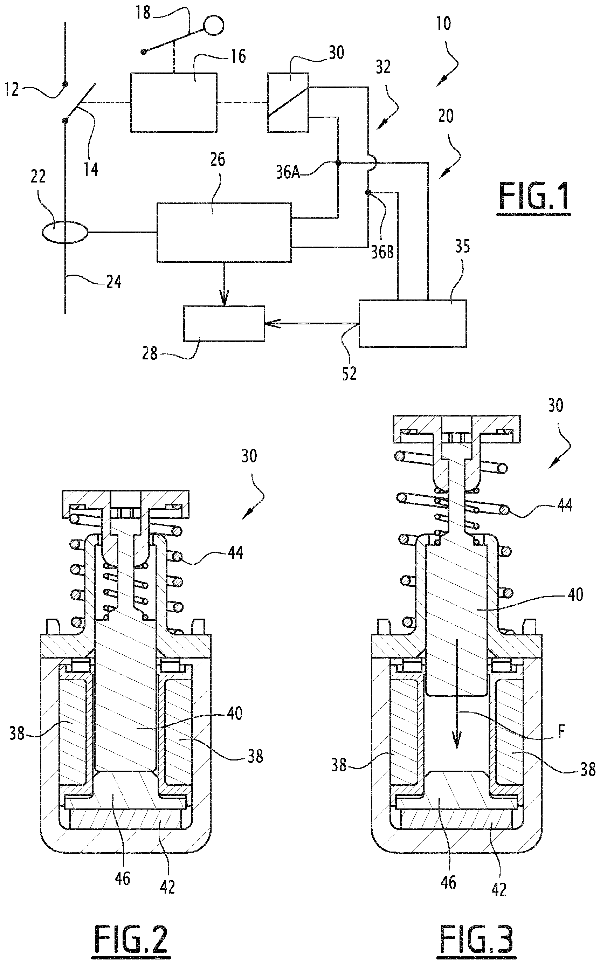

Sur la figure 1, un disjoncteur électrique 10 comprend, comme connu en soi, un contact électrique fixe 12 et un contact électrique mobile 14, le contact mobile 14 étant propre à se déplacer entre une position ouverte dans laquelle les contacts fixe et mobile 12, 14 sont séparés, et une position fermée dans laquelle le contact mobile14 est en appui contre le contact fixe 12.

Le disjoncteur électrique 10 comprend un mécanisme 16 de séparation des contacts, une manette 18 de réarmement du mécanisme de la position ouverte vers la position fermée du contact mobile et un actionneur 20 du mécanisme de séparation, la manette de réarmement 18 et l'actionneur 20 étant chacun couplé mécaniquement au mécanisme de séparation 16.

Le disjoncteur électrique 10 comprend un capteur 22 du courant circulant dans un conducteur électrique 24 relié au contact fixe 12. Le disjoncteur électrique 10 comprend une unité de traitement 26 reliée au capteur de courant 22, l'unité de traitement 26 étant propre à commander le déclenchement du disjoncteur électrique, c'est-à-dire la séparation des contacts 12, 14, via l'actionneur 20 et le mécanisme de séparation 16, suite à la détection d'un défaut électrique à l'aide du capteur de courant 22.

Le disjoncteur électrique 10 comprend une unité de signalisation 28 reliée à l'unité de traitement 26 et destinée à signaler l'état du disjoncteur électrique 10 à un dispositif électronique externe, non représenté, l'unité de signalisation 28 étant reliée au dispositif externe, par exemple via une liaison radioélectrique.

Le mécanisme de séparation 16 est apte à séparer les contacts 12, 14, lorsqu'il est actionné par l'actionneur 20. Autrement dit, le mécanisme de séparation est apte à provoquer le passage de la position fermée à la position ouverte du contact mobile 14.

La manette de réarmement 18 est propre à réarmer le mécanisme de séparation 16, c'est-à-dire à provoquer le passage de la position ouverte à la position fermée du contact mobile 14, via le mécanisme de séparation 16. La manette de réarmement 18 est, par exemple, actionnée manuellement. On parle alors plus généralement de réarmement du disjoncteur 10.

L'actionneur 20 comprend un relais de déclenchement 30 relié, d'une part, à l'unité de traitement 26 par une liaison de données 32, et d'autre part, couplé mécaniquement au mécanisme de séparation 16. L'actionneur 20 comprend également un dispositif 35 de détection du réarmement du disjoncteur, le dispositif de détection 35 étant couplé à la liaison de données 32 en des points de connexion 36A, 36B.

Le capteur de courant 22 comporte un tore agencé autour du conducteur électrique 24 et propre à mesurer l'intensité du courant circulant dans le conducteur électrique.

L'unité de traitement 26 est propre à détecter un défaut électrique, tel qu'un court-circuit, sur le conducteur électrique 24, notamment à l'aide de l'intensité mesurée par le capteur de courant 22, et à commander le déclenchement du disjoncteur 10 suite à la détection d'un tel défaut. L'unité de traitement 26 est alors propre à générer un signal de commande de la séparation des contacts 12, 14 et à le transmettre au relais de déclenchement 30 via la liaison de données 32.

L'unité de signalisation 28 est propre à transmettre des informations relatives au disjoncteur à destination du dispositif externe, les informations transmises comportant notamment l'état du disjoncteur, la position du contact mobile 12 parmi sa position ouverte et sa position fermée, la détection éventuelle d'un défaut sur le conducteur électrique 24,...

Le relais de déclenchement 30, visible sur les figures 2 et 3, comporte une bobine électromagnétique 38 et un noyau 40 mobile entre une position de repos et une position de travail dans laquelle le mécanisme de séparation 16 est actionné, la bobine 38 étant propre à provoquer le déplacement du noyau mobile 40 de sa position de repos vers sa position de travail.

Le relais de déclenchement 30 comporte un aimant permanent 42 propre à exercer une force d'attraction sur le noyau mobile 40, celui-ci étant de préférence réalisé en un matériau magnétique. Le relais de déclenchement 30 comporte un ressort 44 propre à exercer une force de propulsion sur le noyau mobile 40, cette force de propulsion s'opposant à la force d'attraction de l'aimant permanent 42 sur ledit noyau.

Le relais de déclenchement 30 est un relais à aimant permanent maintenu en position armée par la force magnétique de l'aimant 42 plus élevée que la force de propulsion du ressort 44, le relais passant en position déclenchée lorsqu'un courant circule dans la bobine 38 et crée un flux magnétique opposé au flux magnétique de l'aimant permanent 42.

En position armée du relais 30, le noyau mobile 40 est en contact avec l'aimant permanent 42, une entretoise 46 étant éventuellement disposée entre le noyau mobile 40 et l'aimant permanent 42, comme représenté sur la figure 2.

En position déclenchée du relais 30, le noyau mobile 40 est à l'écart de l'aimant permanent 42, la force de propulsion du ressort 44 additionnée au flux créé par la bobine 38 ayant provoqué l'écartement du noyau mobile 40 par rapport à l'aimant permanent 42, comme représenté sur la figure 3.

Le passage de la position déclenchée à la position armée du relais 30 (flèche F), lors du réarmement du disjoncteur électrique 10, engendre un courant électrique induit dans la bobine 38.

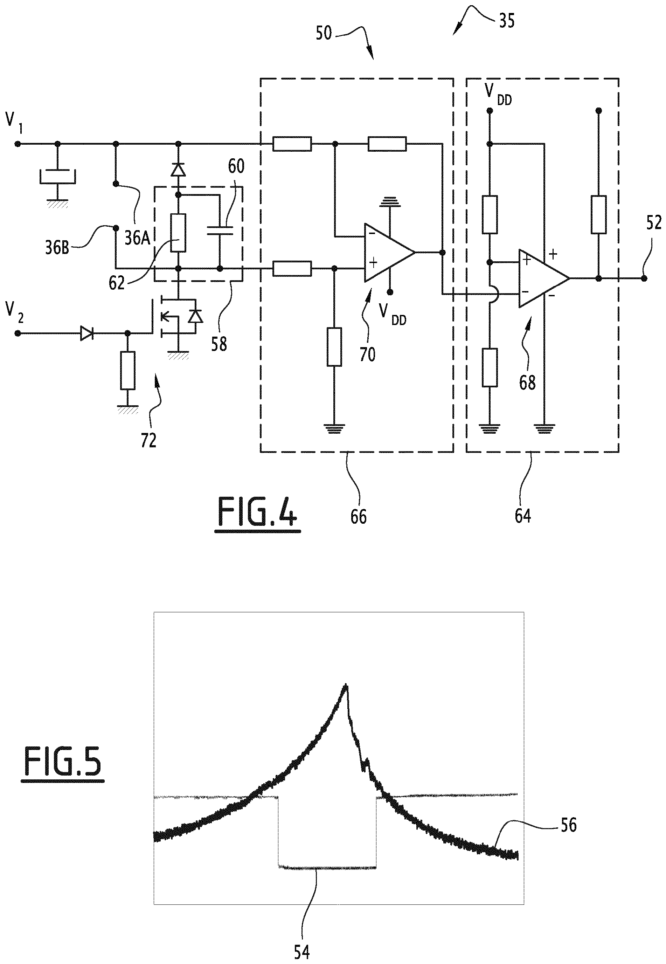

Le dispositif de détection 35 comprend, des moyens 50 de génération, en une borne de sortie 52, d'un signal 54 d'indication du réarmement à partir d'une impulsion électrique 56, comme représenté sur la figure 4, le signal d'indication 54 et l'impulsion électrique 56 étant visibles sur la figure 5.

Les moyens de génération 50, visibles sur la figure 4, comportent un étage 58 de filtrage de l'impulsion électrique, l'étage de filtrage 58 comportant de préférence un condensateur 60 et une résistance 62 connectés en parallèle.

Les moyens de génération 50 comportent un étage 64 de conversion de l'impulsion électrique 56 en un signal carré, également appelé signal créneau, correspondant au signal d'indication 54.

En complément, dans l'exemple de réalisation de la figure 4, les moyens de génération 50 comportent en outre un étage 66 d'amplification différentielle connecté entre l'étage de filtrage 58 et l'étage de conversion 64.

La borne de sortie 52 est, par exemple, connectée à l'unité de signalisation 28, pour la transmission du signal d'indication 54 à l'unité de signalisation 28.

Le signal d'indication 54 est, par exemple, un signal carré, comme représenté sur la figure 5, tel qu'un signal carré, facilement identifiable par l'unité de signalisation 28.

L'impulsion électrique 56 correspond au courant électrique induit dans la bobine 38 par le déplacement du noyau mobile 40 de sa position de travail vers sa position de repos lors du réarmement du disjoncteur 10. Sur le schéma électrique de la figure 4, l'impulsion électrique 56 correspond à la tension V₁, c'est-à-dire à la tension au point de connexion 36A.

L'étage de filtrage 58 est connecté entre les points de connexion 36A, 36B, et est lui-même connecté en entrée de l'étage d'amplification différentielle 66.

L'étage de conversion 64 comporte, par exemple, un premier amplificateur opérationnel 68 dont l'une des bornes d'entrée est à une tension de référence V_{DD} et l'autre borne d'entrée est connectée à la sortie de l'étage d'amplification différentielle 66, la borne de sortie de l'amplificateur opérationnel 68 étant connectée à la borne de sortie 52. Le premier amplificateur opérationnel 68 forme un comparateur de l'impulsion électrique 56 reçue en entrée avec la tension de référence V_{DD}.

L'étage d'amplification différentielle 66 comporte, par exemple, un deuxième amplificateur opérationnel 70 dont l'une des bornes d'entrée est à la tension V₁ et l'autre borne d'entrée est reliée à un circuit de commande 72 apte à délivrer un signal de commande à partir d'une tension V₂.

Ainsi, lorsque le disjoncteur 10 est réarmé, par exemple par actionnement manuel de la manette de réarmement 18, le relais de déclenchement 30 passe de sa position déclenchée à sa position armée, le noyau mobile 40 se déplaçant alors dans le sens de la flèche F à la figure 3, ce qui engendre un courant électrique induit dans la bobine électromagnétique 38. L'impulsion électrique 56 correspondant à ce courant induit est reçue par le dispositif de détection 35 entre les points de connexion 36A, 36B.

L'impulsion électrique reçue 56 est alors d'abord filtrée par l'étage de filtrage 58, avant d'être amplifiée par l'étage amplification différentielle 66, puis d'être convertie par l'étage de conversion 64 en le signal d'indication du réarmement 54. Le signal d'indication du réarmement 54 est transmis à l'unité de signalisation 28, afin que l'information du réarmement du disjoncteur électrique 10 soit transmise au dispositif externe.

L'impulsion électrique 56 correspondant au courant électrique induit dans la bobine 38 de l'actionneur 20 du mécanisme 16 de séparation des contacts fixe et mobile 12, 14 du disjoncteur électrique 10 est ainsi utilisée pour générer le signal 54 d'indication du réarmement du disjoncteur 10, le courant étant induit dans la bobine 38 par le déplacement du noyau mobile 40 de sa position de travail vers sa position de repos lors du réarmement du disjoncteur 10.

On conçoit ainsi que le dispositif de détection 35 est particulièrement simple à mettre en oeuvre puisqu'il suffit de le connecter entre le relais de déclenchement 30 et l'unité de traitement 26, tout en étant peu coûteux en l'absence de capteur de position.

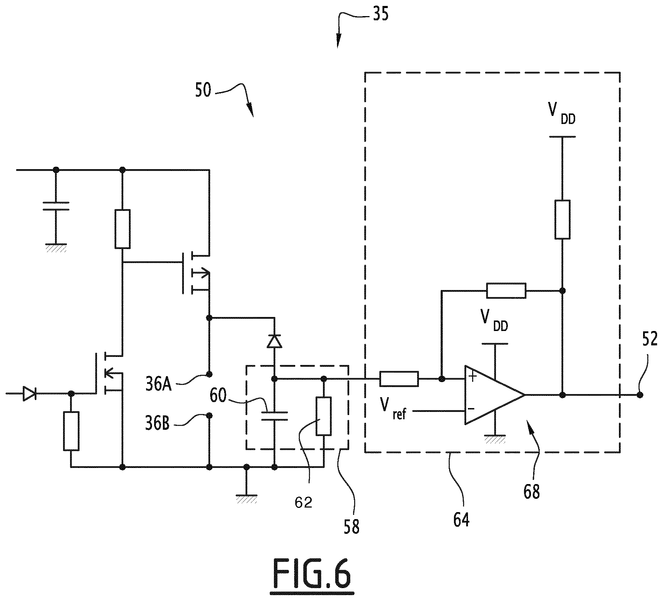

La figure 6 illustre un deuxième mode de réalisation, pour lequel les éléments identiques au premier mode de réalisation, décrit précédemment, sont repérés par des références identiques.

Selon le deuxième mode de réalisation, les moyens de génération 50 ne comportent pas d'étage d'amplification différentielle, et l'étage de filtrage 58 est connecté directement en entrée de l'étage de conversion 64.

Selon ce deuxième mode de réalisation, le point de connexion 36B est référencé à la masse 80 de l'électronique.

Le premier amplificateur opérationnel 68 de l'étage de conversion est connecté en entrée, d'une part à la sortie de l'étage de filtrage 58, et d'autre part à une tension de référence V_{ref}, le premier amplificateur opérationnel 68 étant connecté en sortie à la borne de sortie 52.

Le fonctionnement de ce deuxième mode de réalisation est analogue à celui du premier mode de réalisation, décrit précédemment, et n'est pas décrit à nouveau.

Les avantages de ce deuxième mode de réalisation analogues à ceux du premier mode de réalisation ne sont pas décrits à nouveau. Le dispositif de détection 35 selon ce deuxième mode de réalisation est encore simplifié, puisqu'il ne comporte pas d'étage d'amplification différentielle.

On conçoit ainsi que le dispositif de détection 35 est particulièrement simple à mettre en oeuvre, tout en étant peu coûteux.

## Revendications

1. Utilisation d'une impulsion électrique (56) correspondant à un courant électrique induit dans une bobine (38) d'un actionneur (20) d'un mécanisme (16) de séparation des contacts fixe et mobile (12, 14) d'un disjoncteur électrique (10), pour générer un signal carré (54) d'indication du réarmement du disjoncteur (10), le contact mobile (14) étant propre à se déplacer entre une position ouverte dans laquelle les contacts fixe et mobile (12, 14) sont séparés et une position fermée dans laquelle le contact mobile (14) est en appui contre le contact fixe (12), ledit disjoncteur électrique (10) comprenant en outre une manette (18) de réarmement du mécanisme (16) de la position ouverte vers la position fermée du contact mobile (14) liée mécaniquement audit actionneur (20), le courant étant induit dans la bobine (38) par le déplacement d'un noyau mobile (40) de sa position de travail vers sa position de repos lors du réarmement du disjoncteur (10), le noyau mobile (40) étant inclus dans l'actionneur (20).

2. Utilisation selon la revendication 1, comprenant un filtrage (58) de l'impulsion électrique (56) par un condensateur (60) et une résistance (62) connectés en parallèle.

3. Utilisation selon la revendication 2, comprenant en outre une amplification différentielle (68) entre le filtrage (58) et la conversion (64).

4. Utilisation selon l'une quelconque des revendications précédentes, dans lequel la conversion (64) comporte l'utilisation d'un comparateur (68) avec une tension de référence.

## Patentansprüche

1. Verwendung eines elektrischen Impulses (56), der einem elektrischen Strom entspricht, der in einer Spule (38) eines Betätigungsglieds (20) eines Mechanismus (16) zum Trennen eines feststehenden und eines beweglichen Kontakts (12, 14) eines elektrischen Schutzschalters (10) induziert wird, um ein Rechtecksignal (54) zur Anzeige der Rückstellung des Schutzschalters (10) zu erzeugen, wobei der bewegliche Kontakt (14) dazu geeignet ist, sich zwischen einer offenen Stellung, in welcher der feststehende und der bewegliche Kontakt (12, 14) getrennt sind, und einer geschlossenen Stellung zu verlagern, in welcher der bewegliche Kontakt (14) am feststehenden Kontakt (12) anliegt, wobei der elektrische Schutzschalter (10) darüber hinaus einen mechanisch mit dem Betätigungsglied (20) verbundenen Hebel (18) zur Rückstellung des Mechanismus (16) von der offenen Stellung in die geschlossene Stellung des beweglichen Kontakts (14) aufweist, wobei der Strom durch die Verlagerung eines beweglichen Kerns (40) von seiner Arbeitsstellung in seine Ruhestellung bei der Rückstellung des Schutzschalters (10) in der Spule (38) induziert wird, wobei der bewegliche Kern (40) im Betätigungsglied (20) enthalten ist.

2. Verwendung nach Anspruch 1, eine Filterung (58) des elektrischen Impulses (56) durch einen Kondensator (60) und einen Widerstand (62) umfassend, die parallelgeschaltet sind.

3. Verwendung nach Anspruch 2, darüber hinaus eine Differenzverstärkung (68) zwischen der Filterung (58) und der Umwandlung (64) umfassend.

4. Verwendung nach einem der vorhergehenden Ansprüche, wobei die Umwandlung (64) die Verwendung eines Komparators (68) mit einer Referenzspannung umfasst.

## Claims

1. A use of an electric pulse (56) corresponding to an electric current induced in a coil (38) of an actuator (20) of a mechanism (16) for separating fixed and moving contacts (12, 14) of an electric circuit breaker (10), to generate a square resetting indication signal (54) of the circuit breaker (10), the moving contact (14) being capable of moving between an open position, in which the fixed and moving contacts (12, 14) are separated, and a closed position, in which the moving contact (14) is pressed against the fixed contact (12), said circuit breaker (10) further comprising a lever (18) for resetting the mechanism (16) from the open position to the closed position of the moving contact (14), mechanically coupled to said actuator (20), the current being induced in the coil (38) by the movement of a moving core (40) from its working position to its idle position when the circuit breaker (10) is reset, the moving core (40) being included in the actuator (20).

2. Use according to claim 1, comprising a filtering (58) of the electric pulse (56) by means of a capacitor (60) and a resistance (62) connected in parallel.

3. Use according to claim 2, further comprising a differential amplification (68) between the filtering (58) and the conversion (64).

4. Use according to any of the preceding claims, wherein the conversion (64) comprises the use of a comparison (68) with a reference voltage.
